# EUROPÄISCHE PATENTSCHRIFT

(11) **EP 2 890 225 B1**
(45) Veröffentlichungstag und Bekanntmachung des Hinweises auf die Patenterteilung: **01.03.2017**
(21) Anmeldenummer: 14197156.4
(22) Anmeldetag: 10.12.2014
(51) Int. Cl.: H05K 1/11, H02K 11/00, H02K 15/00, H02K 11/215, H05K 1/02, H05K 1/18

(54) **Programmierbare Elektronikbaugruppe**
Programmable electronics assembly
Bloc électronique programmable

(30) Priorität: 13.12.2013 DE 102013114024
(43) Veröffentlichungstag der Anmeldung: 01.07.2015
(73) Patentinhaber: Dr. Fritz Faulhaber GmbH & Co. KG, 71101 Schönaich (DE)
(72) Erfinder: Scholl, Thomas, 72768 Reutlingen (DE); Schneider, Thomas, 72768 Reutlingen (DE)
(74) Vertreter: Patent- und Rechtsanwälte Dr. Solf & Zapf

(56) Entgegenhaltungen:
- EP-A1- 0 511 474
- EP-A1- 1 271 749
- EP-A2- 1 858 312
- US-A1- 2007 109 729
- US-A1- 2009 212 651

## Beschreibung

Die vorliegende Erfindung betrifft eine programmierbare Elektronikbaugruppe, umfassend eine Leiterplatte mit elektrischen Leiterbahnen und auf den Leiterbahnen kontaktierte Elektronikbauteile einschließlich eines programmierbaren Elektronikbauteils, insbesondere eines Sensor-Bauteils wie einen Encoder oder einen Bewegungssensor, sowie mit den Leiterbahnen verbundene elektrische Kontaktflächen zum Kontaktieren von Kontaktierstiften einer externen Programmiereinheit, wobei die Leiterplatte einen die Elektronikbauteile aufweisenden Montageabschnitt sowie einen von diesem wegführenden Anschlussabschnitt aufweist.

Zur Programmierung bzw. Konfiguration von beispielsweise in Antriebssystemen wie elektrischen Kleinstmotoren integrierten Elektronikbaugruppen, wie Encoder, Speed Controller, Motion Controller o.ä., ist in der Regel eine elektrische Kontaktierung mittels Kontaktierstiften der Elektronikbaugruppe in einer Montagevorrichtung erforderlich. Es ist üblich, dass diese Kontaktierung der Elektronikbaugruppe in einem der letzten Montageschritte erfolgt, bevor z. B. das Gehäuse des Antriebs eines elektrischen Kleinstmotors, in dem die Elektronikbaugruppe enthalten ist, verschlossen wird. Um eine zuverlässige und kostengünstige Kontaktierung in der Montagevorrichtung sicherzustellen, können die Abmessungen der für die Kontaktierung erforderlichen Kontaktflächen nicht beliebig klein gewählt werden. Somit bereitet die Integration dieser Kontaktflächen insbesondere bei Kleinstmotoren große Schwierigkeiten. Bei derartigen Kleinstmotoren ist es erforderlich, dass das zu programmierende Bauteil, insbesondere ein Sensorchip, präzise zum Rotor, d. h. zu einem Gebermagneten des Rotors ausgerichtet werden muss. Dadurch werden sekundäre Bauelemente wie die Leiterplatte nicht mehr so exakt positioniert, wodurch es zu Einschränkungen bei der zuverlässigen automatischen Kontaktierung mittels anzuschließender Kontaktierstifte aufgrund der sehr geringen Größe der Kontaktflächen kommt, da die Position der Kontaktflächen aufgrund der erforderlichen Ausrichtung ungenau ist. Auch wird eine Ungenauigkeit in der Regel durch die Fertigungstoleranzen bei der Leiterplattenherstellung, durch die es zu einem nicht zu vernachlässigenden Versatz zwischen Leiterbild und Kontur der Leiterplatte kommt, verursacht, insbesondere wenn kostengünstige Herstellprozesse für die Leiterplatte verwendet werden.

Eine programmierbare Elektronikbaugruppe gemäß dem Oberbegriff von Anspruch 1 und ein Gleichstrom-Kleinstmotor gemäß dem Oberbegriff von Anspruch 17 sind aus der Offenbarung US-A1-2007/0109729 bekannt.

Der vorliegenden Erfindung liegt die Aufgabe zu Grunde, die vorstehenden Nachteile zu vermeiden und eine zuverlässige und kostengünstige Kontaktierung der Kontaktflächen zu ermöglichen.

Diese Aufgabe wird durch den Gegenstand der Ansprüche 1 und 17 gelöst.

Erfindungsgemäß wird dies dadurch erreicht, dass an dem Montageabschnitt ein Fortsatz der Leiterplatte ausgebildet ist, der die elektrischen Kontaktflächen zum Anschluss der Kontaktierstifte aufweist, und der über einen Materialschwächungsbereich mit dem Montageabschnitt verbunden ist. Dieser Fortsatz ist derart dimensioniert, dass er über ein Gehäuse zur Aufnahme der erfindungsgemäßen Baugruppe, insbesondere eines Kleinstmotors hinausragt, so dass die Kontaktflächen gegenüber dem Gehäusemantel vorstehen und somit leicht mittels Kontaktierstiften kontaktiert werden können. Nach der erfolgten Kontaktierung kann über den erfindungsgemäß vorgesehenen Materialschwächungsbereich der Fortsatz leicht abgetrennt werden, so dass er am fertigen Gerät, z. B. einem Motor nicht mehr störend vorhanden ist. Der Materialschwächungsbereich befindet sich zweckmäßigerweise unmittelbar am Übergang zwischen dem Fortsatz und dem Montageabschnitt.

Erfindungsgemäß ist es hierbei vorteilhaft, wenn die Kontaktflächen als beidseitige Kontaktflächen, d. h. als Bottom- und Top-Kontaktflächen, ausgebildet sind, so dass eine automatische Kontaktierung erfolgen kann. Zudem ist es erfindungsgemäß zweckmäßig, wenn im Fortsatz eine Passbohrung vorhanden ist, wodurch eine präzise Ausrichtung der Kontaktflächen in einer Montagevorrichtung möglich ist.

Weiterhin ist es erfindungsgemäß von Vorteil, wenn zum Toleranzausgleich der Positionen zwischen dem Gerät, z. B. dem Antrieb des Kleinstmotors und einer Montagevorrichtung ein flexibler Bereich z. B. aus Polyimid zwischen dem Materialschwächungsbereich und den Kontaktflächen in dem erfindungsgemäßen Fortsatz ausgebildet ist. Der flexible Bereich ist zweckmäßigerweise aus einem flexibleren Material als der Montageabschnitt und der Fortsatz. Erfindungsgemäß ist es zudem zweckmäßig, wenn der Fortsatz an seinem freien Ende streifenförmige Kontaktflächen aufweist, die zur manuellen Kontaktierung über standardisierte Steckverbinder dienen können.

Indem im Materialschwächungsbereich eine Aussparungsöffnung ausgebildet ist, werden die abzutrennenden Längen in diesem Materialschwächungsbereich verkürzt. Diese Aussparungsöffnung ist zweckmäßig derart angeordnet, dass das programmierbare Elektronikbauteil mit einem Teil-Bereich, z. B. einem Eckbereich, sichtbar ist. Hierdurch kann vermieden werden, dass beim Trennen mit einem Schneidwerkzeug das Bauteil beschädigt wird. Weiterhin können in den Seitenrändern des Materialschwächungsbereiches spitzwinklig verlaufende Einschnitte ausgebildet sein, wodurch ebenfalls das Abtrennen des erfindungsgemäßen Fortsatzes erleichtert wird. Da nach dem Abtrennen des erfindungsgemäßen Fortsatzes an den Schnittkanten die Leiterbahnen sichtbar und nicht durch eine Verzinnung oder eine Vergoldung abgedeckt sind, kann leicht überprüft werden, ob ein derartiger Fortsatz am Montageabschnitt entfernt worden ist. Die Trennkante des Fortsatzes liegt insbesondere auf einem Hüllkreis des Montageabschnittes.

Die vorliegende Erfindung bezieht sich auch auf einen elektrischen Kleinstmotor mit einer erfindungsgemäßen programmierbaren Elektronikbaugruppe mit insbesondere einem Motor-Außendurchmesser kleiner/gleich 22 mm.

Vorteilhafte Ausführungen der Erfindung sind in den Unteransprüchen enthalten und werden anhand des in den beiliegenden Zeichnungen dargestellten Ausführungsbeispiels näher erläutert. Es zeigen:
- Fig. 1: eine Draufsicht auf eine erfindungsgemäße programmierbare Elektronikbaugruppe,
- Fig. 2: eine Seitenansicht der Baugruppe gemäß Fig. 1,
- Fig. 3: eine Rückansicht auf die erfindungsgemäße Baugruppe gemäß Fig. 1,
- Fig. 4: einen Schnitt durch einen erfindungsgemäßen Kleinstmotor mit integrierter Elektronikbaugruppe,
- Fig. 5: einen Schnitt als Prinzipdarstellung durch eine Montagevorrichtung für eine erfindungsgemäße Elektronikbaugruppe an einem Motor gemäß Fig. 4, und
- Fig. 6: eine Draufsicht gemäß Fig. 1, wobei der Verlauf von Leiterbahnen erkennbar ist.

In den verschiedenen Figuren sind gleiche Teile mit denselben Bezugszeichen versehen.

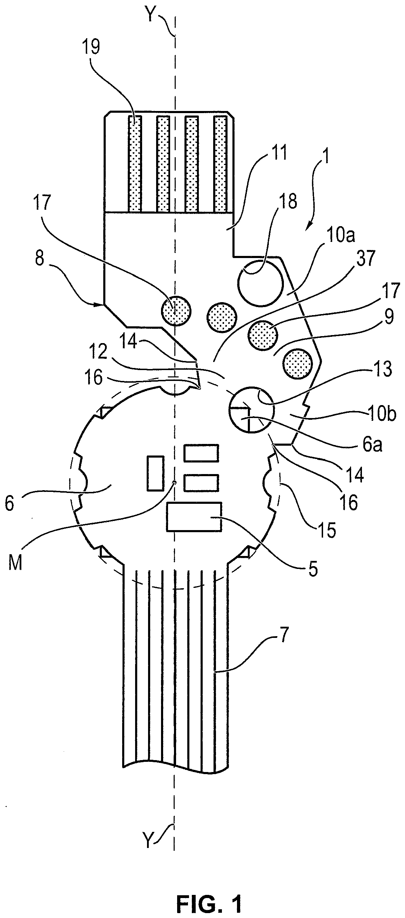

In Bezug auf die anschließende Beschreibung der Figuren 1 bis 6 wird klarstellend als zu der vorliegenden Erfindung gehörig beansprucht, dass die Erfindung nicht auf die Ausführungsbeispiele und deren Merkmalskombinationen beschränkt ist, vielmehr ist jedes einzelne Merkmal des jeweiligen Ausführungsbeispiels auch unabhängig von allen anderen im Zusammenhang damit beschriebenen Merkmalen für sich und auch in Kombination mit weiteren Merkmalen erfindungswesentlich für die Erfindung.

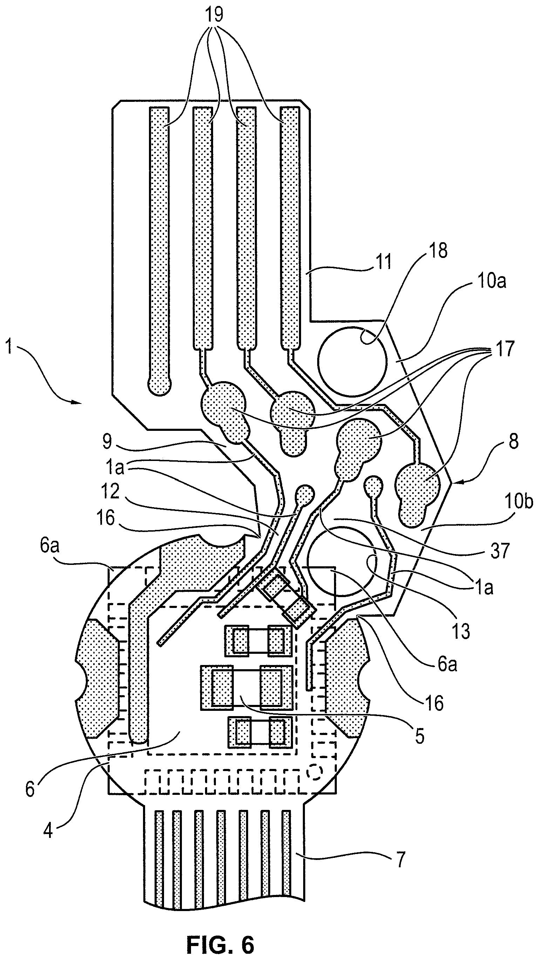

Wie sich aus Fig. 1 und Fig. 6 ergibt, umfasst eine erfindungsgemäße programmierbare Elektronikbaugruppe eine Leiterplatte 1, die elektrisch leitende Leiterbahnen 1 a aufweist. Auf der Leiterplatte 1 sind Elektronikbauteile auf den Leiterbahnen 1a angeordnet, wobei diese Elektronikbauteile 4, 5 ein programmierbares Bauteil 4, z. B. ein Sensorbauteil, wie einen Encoder oder einen Bewegungssensor oder dergleichen umfassen, sowie weitere elektronische Bauteile 5 einer Steuer- oder Messelektronik. Das programmierbare Bauteil 4 ist vorzugsweise auf einer Seite der Leiterplatte 1 befestigt, und die anderen Bauteile 5 sind z. B. auf der gegenüberliegenden Seite der Leiterplatte 1 angeordnet. Bei der Leiterplatte 1 handelt es sich beispielsweise um eine starre, starr flexible oder um eine flexible Leiterplatte. Eine flexible Leiterplatte ist z. B. aus Polyimid gefertigt. Die erfindungsgemäße Leiterplatte 1 weist einen Montageabschnitt 6 auf, auf dem die Elektronikbauteile 5 und das programmierbare Bauteil 4 angeordnet sind, sowie einen von dem Montageabschnitt 6 weg sich erstreckenden Anschlussabschnitt 7. Dieser Anschlussabschnitt 7 ist zweckmäßigerweise bandförmig ausgebildet, d. h. seine Längenerstreckung ist größer als seine Breite. Er besitzt z. B. eine Breite von 3,6 mm. Im dargestellten vorteilhaften Ausführungsbeispiel ist der Montageabschnitt 6 kreisförmig ausgebildet, d. h. er wird von einer kreisförmigen Hüllkurve 15 umfasst, die um einen Mittelpunkt M des Montageabschnitts 6 verläuft und auf der von einer idealen Kreisform abweichende radiale Vorsprünge oder dergleichen liegen. Diese Hüllkurve 15 besitzt z. B. einen Durchmesser von 6,6 mm. Die Grundfläche des programmierbaren Elektronikbauteils 4 deckt z. B. über 50 % der Montagefläche des Montageabschnittes 6 ab. Auf der dem Anschlussabschnitt 7 gegenüberliegenden Seite des Montageabschnittes 6, z. B. einseitig versetzt zu einer durch den Mittelpunkt M des Montageabschnittes 6 verlaufenden mittleren Längsachse Y-Y des Anschlussabschnittes 7, ist ein Fortsatz 8 an dem Montageabschnitt 6 angeformt. Dieser Fortsatz 8 kann sich insbesondere aus zwei Teilabschnitten 9, 11 zusammensetzen, und zwar einem ersten, z. B. aus zwei stumpfwinklig ineinander übergehenden Schenkeln 10a, 10b bestehenden Teilabschnitt 9, und einem zweiten, sich in Verlängerung des Anschlussabschnittes 7 z. B. diesem diametral gegenüberliegend an den ersten Teilabschnitt 9 anschließenden Teilabschnitt 11. Jedoch kann der Fortsatz 8 gemäß der Erfindung auch z. B. in Verlängerung des Anschlussabschnittes 7 geradlinig verlaufen. Auch kann der Fortsatz 8 am Montageabschnitt 6 umfangsgemäß gegenüber dem Anschlussabschnitt 7 um einen beliebigen Umfangswinkel versetzt angeordnet sein.

Zwischen dem Fortsatz 8 und dem Montageabschnitt 6 der erfindungsgemäßen Leiterplatte 1 ist insbesondere ein Materialschwächungsbereich 12 ausgebildet. Dieser Materialschwächungsbereich 12 kann dadurch ausgebildet werden, dass z. B. eine Aussparungsöffnung 13 vorgesehen ist, so dass hierdurch der zwischen den jeweils gegenüberliegenden Seitenkanten 14 des Fortsatzes 8 liegende Materialbereich verkürzt wird, wodurch eine Schwächung in diesem Bereich erreicht wird. Weiterhin kann erfindungsgemäß hierzu vorgesehen sein, dass im unmittelbaren Übergang zwischen dem Montageabschnitt 6 und dem Fortsatz 8 in den gegenüberliegenden Seitenkanten 14 des Fortsatzes 8 spitzwinklige Materialeinschnitte 16 vorgesehen sind. Durch diese Materialeinschnitte 16 wird ebenfalls oder zusätzlich eine Materialschwächung bewirkt. Durch die Aussparungsöffnung 13 und/oder die spitzwinkligen Einschnitte 16 wird die Länge des zwischen den beiden Seitenkanten 14 vorhandenen Materialstegs bzw. der zwischen den Seitenkanten 14 und der Aussparungsöffnung 13 vorhandenen Materialstege verkürzt. Aufgrund der erfindungsgemäßen Ausbildung des Materialschwächungsbereiches 12 kann der Fortsatz 8 leicht von dem Montageabschnitt 6 abgetrennt werden. Eine derartige Abtrennung kann beispielsweise mittels eines geeigneten Schneidwerkzeuges erfolgen. Die Aussparungsöffnung 13 ist insbesondere derart angeordnet, dass z. B. ein Eckbereich 6a des programmierbaren Bauteils 4 sichtbar ist.

Auf dem Fortsatz 8 sind erfindungsgemäß elektrische Kontaktflächen 17 ausgebildet, die über die im Fortsatz 8 vorhandenen Leiterbahnen 1 a mit dem programmierbaren Elektronikbauteil 4 verbunden sind. Über diese Kontaktflächen 17 kann eine elektrische Kontaktierung mit einer Programmiereinrichtung zur Konfiguration bzw. Programmierung des programmierbaren Elektronikbauteils 4 erfolgen. Hierzu werden an den Kontaktflächen 17 Kontaktierstifte 36 einer Programmiervorrichtung angeschlossen. Durch den erfindungsgemäßen Leiterplattenfortsatz 8 wird ermöglicht, dass die Kontaktflächen 17 derart groß gewählt werden können, dass eine gute Zugänglichkeit und eine optimale elektrische Kontaktmöglichkeit zur Verfügung stehen.

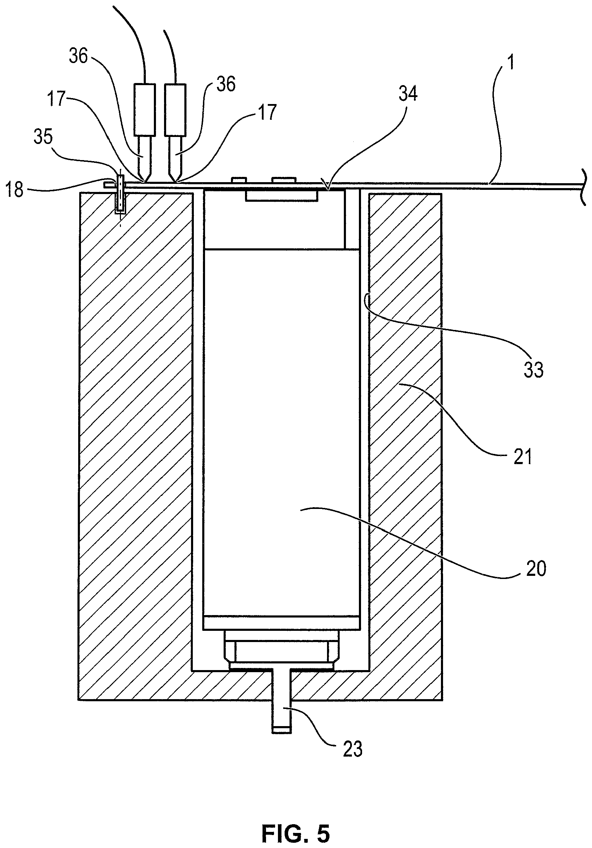

Es kann vorteilhaft sein, wenn beispielsweise vier Kontaktflächen 17 vorhanden sind, die vorzugsweise kreisförmig sind, und wobei es sich z. B. um durchgehende Kontaktflächen handeln kann, die von der Vorderseite zur Rückseite des Fortsatzes 8 verlaufen, so dass es sich um so genannte "Bottom und Top"-Kontaktflächen 17 handelt. Die Kontaktflächen 17 liegen mit ihren Mittelpunkten z. B. auf einem Kreisbogen insbesondere um den Mittelpunkt M des Montageabschnittes 6. Hierbei können die Kontaktflächen 17 auf dem ersten Schenkel 10a und/oder auf dem zweiten Schenkel 10b ausgebildet sein. Die Kontaktflächen 17 liegen insbesondere zumindest teilweise im Winkelbereich der Schenkel 10a, 10b, denn in diesem Bereich ergibt sich durch die Ausbildung des stumpfen Winkels eine größere Fortsatzteilfläche. Gegenüber den Kontaktflächen 17 zum Mittelpunkt M radial nach außen versetzt ist im Fortsatz 8, vorzugsweise im Schenkel 10a des stumpfwinkligen Teilabschnittes 9 eine Passöffnung 18 vorhanden. Mit dieser Passöffnung kann die erfindungsgemäße Leiterplatte 1 in einer Montagevorrichtung 21 (s. Fig. 5) für die Konfiguration und Programmierung des programmierbaren Elektronikbauteils 4 positioniert werden, so dass eine zuverlässige Kontaktierung mittels der Kontaktierstifte der externen Programmiervorrichtung möglich ist. Am freien Ende des Fortsatzes 8 sind streifenförmige Kontaktflächen 19 ausgebildet, über die eine manuelle Kontaktierung über beispielsweise standardisierte Steckverbinder möglich ist.

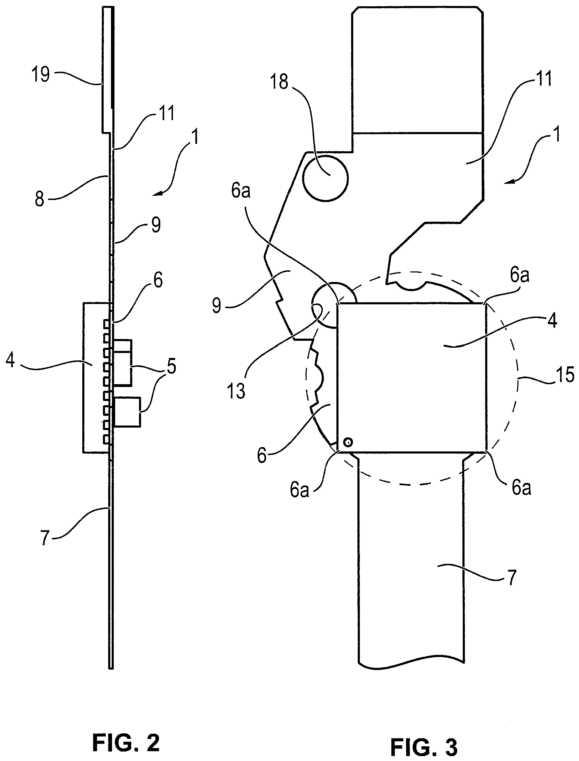

Wie insbesondere aus Fig. 3 zu entnehmen ist, besitzt das programmierbare Bauteil 4 z. B. eine rechteckige, insbesondere quadratische Grundfläche mit einer Kantenlänge von z. B. 5 mm, wobei der Montageabschnitt 6 z. B. derart bemessen ist, dass die Grundfläche mit ihren Eckbereichen 6a auf dem Hüllkreis 15 des Montageabschnittes 6 liegt. Hierdurch erfolgt erfindungsgemäß eine optimale Anpassung der Größe des Montageabschnittes 6 an die Größe des programmierbaren Bauteils 4, jedoch ist es ebenfalls möglich, wenn die Eckbereiche des programmierbaren Bauteils 4 innerhalb oder außerhalb des Hüllkreises 15 liegen.

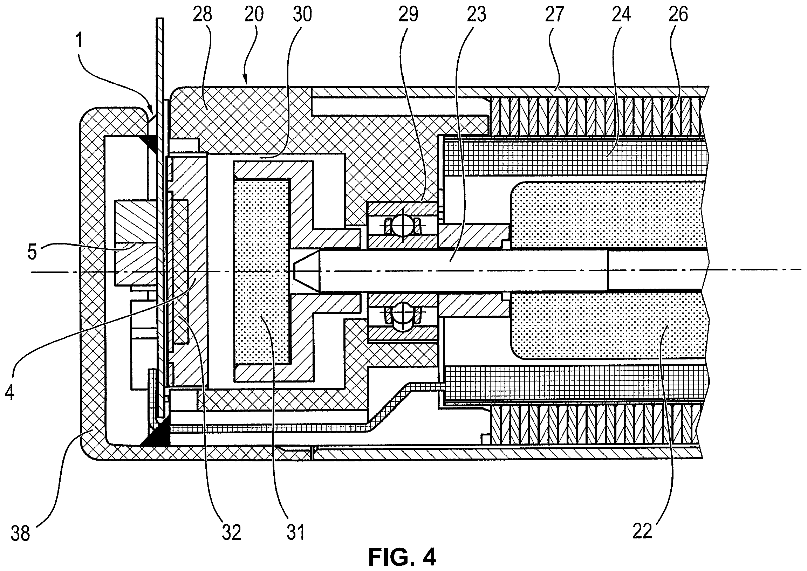

Erfindungsgemäß wird eine erfindungsgemäße programmierbare Elektronikbaugruppe insbesondere in einem Antriebssystem mit integrierten Elektronikbaugruppen, wie Encoder, Speed Controller, Motion Controller o.ä. verwendet. Insbesondere handelt es sich bei dem Antriebssystem um einen bürstenlosen Kleinstmotor mit integriertem Gebermagnet 31. Ein derartiger erfindungsgemäßer Kleinstmotor 20 ist in Fig. 4 dargestellt. Ein derartiger Kleinstmotor 20 weist eine mittlere Rotorwelle 23 auf, auf der ein Rotor-Magnet 22 endseitig befestigt ist. Die Rotorwelle 23 mit dem Rotor-Magneten 22 bilden gemeinsam den Rotor des Kleinstmotors 20 und laufen innerhalb einer diesen einschließenden Wicklung 24. Am Außenumfang der Wicklung 24 befindet sich ein Eisenrückschluss 26, der die Wicklung 24 ebenfalls umfasst. Der Eisenrückschluss 26 und die Wicklung 24 bilden gemeinsam den Stator des erfindungsgemäßen Motors 20. Der Stator aus Eisenrückschluss 26 und Wicklung 24 wird außen umschlossen von einem Motorgehäuse 27, das einendig stirnseitig mit einer Endkappe 28 verschlossen wird. Das Motorgehäuse 27 besitzt z. B. einen Außendurchmesser von 7,3 mm. In dieser Endkappe 28 befindet sich eine Lageraufnahme zur Aufnahme eines Drehlagers 29, in dem die Rotorwelle 23 drehbar gelagert ist. Innerhalb der Endkappe 28 ist konzentrisch zur Rotorwelle 23 ein Aufnahmeraum 30 ausgebildet, in dem der Gebermagnet 31 drehbar angeordnet ist, wobei der Gebermagnet 31 über eine mit der Rotorwelle 23 verbundene Aufnahme drehfest mit der Rotorwelle 23 verbunden ist. In axialer Richtung der Rotorwelle 23 dem Gebermagneten 31 gegenüber ist im dargestellten Ausführungsbeispiel ein erfindungsgemäßes programmierbares Bauteil 4, z. B. ein Encoder 32 oder ein Drehgeber, auf einer erfindungsgemäßen Leiterplatte 1 angeordnet. Die das programmierbare Bauteil 4 aufweisende Leiterplatte 1 ist derart dimensioniert, dass der Hüllkreis 15 ihres Montageabschnittes 6 derart in seinem Durchmesser bemessen ist, dass er kleiner als der Innendurchmesser des Motorgehäuses 27 oder der Endkappe 28 ist. Das zu programmierende Bauteil 4 ist präzise zum Gebermagneten 31 ausgerichtet. In einer Montagevorrichtung 21, wie sie in Fig. 5 dargestellt ist, erfolgt die Programmierung des programmierbaren Bauteils 4 mittels Kontaktierstiften 36. Diese Montagevorrichtung 21 besitzt eine innere zylindrische Aufnahme 33 für den Motor 20 und ist derart bemessen, dass der Motor 20 im eingesetzten Zustand mit der Stirnfläche 34 seiner Endkappe 28 mit einer Stirnfläche der Montagevorrichtung 21 zumindest bündig abschließt. Hierdurch kann die erfindungsgemäße Leiterplatte 1 über die Passöffnung 18 mittels eines Passstiftes 35 lagegenau in der Montagevorrichtung 21 positioniert werden, so dass die Position der auf dem Fortsatz 8 befindlichen Kontaktflächen 17 genau festgelegt ist, weshalb eine automatische Kontaktierung mit den Kontaktierstiften 36 einer Programmiereinrichtung möglich ist, wobei vorteilhafterweise die Kontaktflächen 17 beidseitig der Leiterplatte 1 vorhanden sind. Weiterhin ist es erfindungsgemäß zweckmäßig, wenn zwischen dem Schwächungsbereich 12 und den Kontaktflächen 17 in dem Fortsatz 8 ein flexibler Bereich 37 ausgebildet ist, so dass ein Toleranzausgleich zwischen den Positionen zwischen der Lage der Elektronikbaugruppe in dem Motorantrieb und der Montagevorrichtung 21 erfolgen kann. Die Zugänglichkeit der Kontaktflächen 17 auf dem Fortsatz 8 ist dadurch gegeben, dass der Fortsatz 8 derart ausgebildet ist, dass er über den AußenDurchmesser des Motorgehäuses 27 vorsteht und insbesondere durch einen Spalt 39 zwischen dem Motorgehäuse 27 und der Endkappe 28 verläuft. Wie aus Fig. 4 ersichtlich ist, wird der erfindungsgemäße Kleinstmotor 20 nach Montage der erfindungsgemäßen Leiterplatte 1 mit dem darauf befindlichen programmierbaren Bauteil 4 und der gesamten elektronischen Baugruppe 5 endseitig mit einer Abdeckkappe 38 verschlossen, wodurch der Elektronikbauteilbereich geschützt wird. Aus dem derart verschlossenen Gehäuse ragt radial nach außen der Anschlussabschnitt 7 der erfindungsgemäßen Elektronikbaugruppe heraus. Durch die erfindungsgemäße Ausbildung der Leiterplatte 1 kann nach der erfolgten Programmierung des programmierbaren Elektronikbauteils 4 über die an den Kontaktflächen 17 angesetzten Kontaktierstiften 36 in der Montagevorrichtung 21 der Fortsatz 8 im Bereich der Materialschwächung 12 leicht abgeschnitten bzw. entfernt werden, so dass dieser Fortsatz 8 am fertig montierten und einsatzbereiten Motor 20 nicht mehr vorhanden ist. Hierzu ist es vorteilhaft, wenn der Bereich bzw. Abschnitt der Materialschwächung 12 auf dem Außendurchmesser des Motorgehäuses 27 und/oder der Endkappe 28 liegt. Der Fortsatz 28 schließt nach dem Durchtrennen an der Materialschwächung 12 bündig mit dem Motorgehäuse 27 oder der Endkappe 28 ab, oder liegt endseitig unterhalb deren Umfang. Damit wird eine automatische Kontaktierung zur Programmierung des elektronischen programmierbaren Bauteils 4 auch bei erfindungsgemäßen Kleinstmotoren, die einen Durchmesser kleiner/gleich 22 mm besitzen, zuverlässig und kostengünstig ermöglicht.

In Fig. 6 ist beispielhaft ein Verlauf der Leiterbahnen 1a im Fortsatz 8 und im Materialschwächungsbereich 12 dargestellt. Der Fortsatz 8 besitzt z. B. eine Breite von 4,5 mm.

Die Verwendung einer erfindungsgemäßen Elektronikbaugruppe ist nicht auf Kleinstmotoren der beschriebenen Art beschränkt, sondern kann auch bei anderen elektronischen Geräten zum Einsatz kommen, bei denen eine Konfiguration und Programmierung von integrierten Elektronikbaugruppen erforderlich ist, und wobei der freie zur Verfügung stehende Flächenbereich des Montageabschnittes der Leiterplatte zu klein ist, um Kontaktflächen vorzusehen, so dass eine zuverlässige Programmierung des zu programmierenden Bauteils erfolgen kann.

Die Erfindung ist nicht auf die dargestellten und beschriebenen Ausführungsbeispiele beschränkt, sondern umfasst auch alle Ausführungen im Rahmen des Schutzumfangs der unabhängigen Ansprüche.

## Patentansprüche

1. Programmierbare Elektronikbaugruppe zum Einbau in ein Gehäuse eines Elektromotors, umfassend eine Leiterplatte (1) mit elektrischen Leiterbahnen (1 a) und auf den Leiterbahnen (1 a) kontaktierte Elektronikbauteile (5) einschließlich eines programmierbaren Elektronikbauteils(4), insbesondere eines Sensor-Bauteils wie einen Encoder oder einen Bewegungssensor, sowie mit den Leiterbahnen (1a) verbundene elektrische Kontaktflächen (17) zum Kontaktieren von Kontaktierstiften (36) einer externen Programmiereinheit (21), wobei die Leiterplatte (1) einen die Elektronikbauteile (4, 5) aufweisenden Montageabschnitt (6) sowie einen von diesem wegführenden Anschlussabschnitt (7) aufweist, wobei der Anschlussabschnitt (7) bandförmig ausgebildet ist und sich von dem Montageabschnitt (6) weg erstreckt, und an dem Montageabschnitt (6) ein Fortsatz (8) der Leiterplatte (1) ausgebildet ist, der die elektrischen Kontaktflächen (17) zum Anschluss der Kontaktierstifte (36) aufweist, und der über einen Materialschwächungsbereich (12) mit dem Montageabschnitt (6) verbunden ist, wobei sich der Materialschwächungsbereich (12) unmittelbar an den Montageabschnitt (6) anschließt,
**dadurch gekennzeichnet, dass** der Elektromotor ein elektrischer Kleinstmotor ist und der Fortsatz (8) auf einer dem Anschlussabschnitt (7) gegenüberliegenden Seite in Verlängerung des Anschlussabschnittes (7) geradlinig verläuft oder umfangsgemäß gegenüber dem Anschlussabschnitt (7) um einen beliebigen Umfangswinkel versetzt angeordnet ist und zwischen den elektrischen Kontaktflächen (17) und dem Materialschwächungsbereich (12) ein flexibler Abschnitt (37) in dem Fortsatz (8) derart ausgebildet ist, dass ein Toleranzausgleich zwischen den Positionen des Montageabschnittes (6) und den zu kontaktierenden Kontaktstiften (36) möglich ist.

2. Programmierbare Elektronikbaugruppe nach Anspruch 1,
**dadurch gekennzeichnet, dass** der flexible Abschnitt (37) aus einem Material besteht, das eine größere Flexibilität besitzt als das Material des Montageabschnittes (6) und/oder das Material des Fortsatzes (8) außerhalb des flexiblen Abschnittes (37).

3. Programmierbare Elektronikbaugruppe nach Anspruch 1 oder 2,
**dadurch gekennzeichnet, dass** der flexible Abschnitt (37) aus Polyimid besteht.

4. Programmierbare Elektronikbaugruppe nach einem der Ansprüche 1 bis 3,
**dadurch gekennzeichnet, dass** am Fortsatz (8) einendig an seinem freien Ende elektrische streifenförmige Kontaktflächen (19) zum Anschluss eines elektrischen Steckverbinders vorgesehen sind, wobei die Kontaktflächen (19) mit den Kontaktflächen (17) elektrisch leitend verbunden sind.

5. Programmierbare Elektronikbaugruppe nach einem der Ansprüche 1 bis 4,
**dadurch gekennzeichnet, dass** der Fortsatz (8) sich aus zwei Teilabschnitten (9, 11) zusammensetzt, wobei ein erster mit dem Montageabschnitt (6) verbundener Teilabschnitt (9) von zwei stumpfwinkeligen ineinander übergehenden Schenkeln (10a, 10b) gebildet wird und der zweite Teilabschnitt (11) sich an den Schenkel (10a) radial nach außen gerichtet anschließt.

6. Programmierbare Elektronikbaugruppe nach Anspruch 5,
**dadurch gekennzeichnet, dass** der zweite Teilabschnitt (11) dem Anschlussabschnitt (7) diametral gegenüberliegt.

7. Programmierbare Elektronikbaugruppe nach Anspruch 5 oder 6,
**dadurch gekennzeichnet, dass** die elektrischen Kontaktflächen (17) zumindest teilweise im Übergangsbereich der stumpfwinkelig zueinander verlaufenden Schenkel (10a, 10b) des Teilabschnittes (9) angeordnet sind.

8. Programmierbare Elektronikbaugruppe nach einem der Ansprüche 1 bis 7,
**dadurch gekennzeichnet, dass** die Kontaktflächen (17) mit ihrem Mittelpunkt auf einem Kreisbogen insbesondere um den Mittelpunkt (M) des Montageabschnittes (6) angeordnet sind.

9. Programmierbare Elektronikbaugruppe nach einem der Ansprüche 1 bis 8,
**dadurch gekennzeichnet, dass** innerhalb des Fortsatzes (8) außerhalb des flexiblen Bereiches (37) eine Passöffnung (18) ausgebildet ist.

10. Programmierbare Elektronikbaugruppe nach Anspruch 9,
**dadurch gekennzeichnet, dass** die Passöffnung (18) im Schenkel (10a) des Teilabschnittes (9) gegenüber den Kontaktflächen (36) nach außen versetzt angeordnet ist.

11. Programmierbare Elektronikbaugruppe nach einem der Ansprüche 1 bis 10,
**dadurch gekennzeichnet, dass** der Materialschwächungsbereich (12) eine Aussparungsöffnung (13) umfasst.

12. Programmierbare Elektronikbaugruppe nach einem der Ansprüche 1 bis 11,
**dadurch gekennzeichnet, dass** der Materialschwächungsbereich (12) zwischen den einander gegenüberliegenden Seitenkanten (14) des Fortsatzes (8) stegförmig verläuft.

13. Programmierbare Elektronikbaugruppe nach Anspruch 12,
**dadurch gekennzeichnet, dass** die Seitenkanten (14) des Fortsatzes (8) im Bereich des Materialschwächungsbereiches (12) als spitzwinkelige Materialeinschnitte (16) ausgebildet sind.

14. Programmierbare Elektronikbaugruppe nach einem der Ansprüche 1 bis 13,
**dadurch gekennzeichnet, dass** die Leiterplatte (1) aus einer starren, starr flexiblen oder einer flexiblen Leiterplattenstruktur gebildet ist, wobei eine flexible Leiterplattenstruktur insbesondere aus Polyimid gebildet ist.

15. Programmierbare Elektronikbaugruppe nach einem der Ansprüche 1 bis 14,
**dadurch gekennzeichnet, dass** die Kontaktflächen (17) als beidseitige, so genannte "Bottom und Top"-Kontaktflächen ausgebildet sind.

16. Programmierbare Elektronikbaugruppe nach einem der Ansprüche 1 bis 15,
**dadurch gekennzeichnet, dass** das programmierbare Bauteil (4) eine rechteckige, insbesondere quadratische Grundfläche aufweist, deren Eckbereiche (6a) auf dem Hüllkreis (15) oder innerhalb oder außerhalb des Hüllkreises (15) des Montageabschnittes (6) liegen.

17. Gleichstrom-Kleinstmotor (20) insbesondere mit einem Motordurchmesser kleiner/gleich 22 mm, insbesondere bürstenloser Kleinstmotor, mit integriertem Gebermagnet (31) und mit einem Rotor aus einer mittleren Rotorwelle (23), auf der ein Rotormagnet (22) befestigt ist, wobei der Rotor von einer Wicklung (24) und diese von einem Eisenrückschluss-Teil (26) umschlossen ist, die gemeinsam einen Stator bilden, wobei der Stator außen von einem Motorgehäuse (27) umschlossen wird, das einendig stirnseitig mit einer Endkappe (28) versehen ist, in der die Rotorwelle (23) in einer Lageraufnahme und ein mit der Rotorwelle (23) verbundener Gebermagnet (31) drehbar gelagert sind, wobei dem Gebermagnet (31) ein Encoder (32) oder ein Drehgeber, die jeweils ein programmierbares elektronisches Bauteil (4) bilden, zugeordnet ist,
**dadurch gekennzeichnet, dass** das programmierbare elektronische Bauteil (4) in einer programmierbaren Elektronikbaugruppe nach einem der Ansprüche 1 bis 16 enthalten ist, wobei der Montageabschnitt (6) eine von seiner Hüllkurve (13) gebildete Umfangskontur aufweist, die der Umfangskontur des Motorgehäuses (27) angepasst ist, und der Fortsatz (8) derart bemessen ist, dass er über den Außendurchmesser des Motorgehäuses (27) vorsteht, und der Bereich der Materialschwächung (12) auf dem Außendurchmesser des Motorgehäuses (27) und/oder auf dem der die Elektronikbaugruppe umschließenden Endkappe (28) angeordnet ist.

18. Gleichstrom-Kleinstmotor (20) nach Anspruch 10,
**dadurch gekennzeichnet, dass** die Hüllkurve (15) einen Durchmesser kleiner/gleich 20 mm besitzt.

19. Gleichstrom-Kleinstmotor (20) nach Anspruch 17 oder 18,
**dadurch gekennzeichnet, dass** der Fortsatz (8) durch einen Spalt (39) zwischen dem Motorgehäuse (27) und der Endkappe (28) verläuft.

## Claims

1. Programmable electronics assembly for installation into a housing of an electric motor, comprising a printed circuit board (1) having electrical conductor tracks (1a) and electronic components (5) which are contact-connected on the conductor tracks (1a) and include a programmable electronics component (4), in particular a sensor component such as an encoder or a motion sensor, and also having electrical contact areas (17), which are connected to the conductor tracks (1a), for contact-connection of contact-making pins (36) of an external programming unit (21), wherein the printed circuit board (1) has a mounting section (6), which has the electronics components (4, 5), and a connection section (7) which leads away from the said mounting section, wherein the connection section (7) is of strip-like design and extends away from the mounting section (6), and a projection (8) of the printed circuit board (1) is formed on the mounting section (6), the said projection having the electrical contact areas (17) for connection of the contact-making pins (36) and being connected to the mounting section (6) by means of a region (12) of material weakness, wherein the region (12) of material weakness directly adjoins the mounting section (6),
**characterized in that** the electric motor is a miniature electric motor and the projection (8) runs in a rectilinear manner in an extension of the connection section (7) on a side which is situated opposite the connection section (7) or is arranged offset through an arbitrary circumferential angle in relation to the connection section (7) over the circumference, and a flexible section (37) in the projection (8) is formed between the electrical contact areas (17) and the region (12) of material weakness in such a way that tolerance compensation between the positions of the mounting section (6) and the contact pins (36) with which contact is to be made is possible.

2. Programmable electronics assembly according to Claim 1,
**characterized in that** the flexible section (37) consists of a material which has a greater degree of flexibility than the material of the mounting section (6) and/or the material of the projection (8) outside the flexible section (37).

3. Programmable electronics assembly according to Claim 1 or 2,
**characterized in that** the flexible section (37) consists of polyimide.

4. Programmable electronics assembly according to one of Claims 1 to 3,
**characterized in that** the electrical strip-like contact areas (19) for connection of an electrical plug connector are provided on one end of the projection (8) at its free end, wherein the contact areas (19) is electrically conductively connected to the contact areas (17).

5. Programmable electronics assembly according to one of Claims 1 to 4,
**characterized in that** the projection (8) is made up of two subsections (9, 11), wherein a first subsection (9), which is connected to the mounting section (6), is formed by two limbs (10a, 10b) which merge with one another at an obtuse angle, and the second subsection (11) adjoins the limb (10a) in a manner directed radially to the outside.

6. Programmable electronics assembly according to Claim 5,
**characterized in that** the second subsection (11) is situated diametrically opposite the connection section (7).

7. Programmable electronics assembly according to Claim 5 or 6,
**characterized in that** the electrical contact areas (17) are arranged at least partially in the transition region of the limbs (10a, 10b) of the subsection (9) which run at an obtuse angle in relation to one another.

8. Programmable electronics assembly according to one of Claims 1 to 7,
**characterized in that** the contact areas (17) are arranged with their centre point on an arc of a circle, in particular around the centre point (M) of the mounting section (6).

9. Programmable electronics assembly according to one of Claims 1 to 8,
**characterized in that** a fitting opening (18) is formed within the projection (8) outside the flexible region (37).

10. Programmable electronics assembly according to Claim 9,
**characterized in that** the fitting opening (18) is arranged in the limb (10a) of the subsection (9) in a manner offset to the outside in relation to the contact areas (36).

11. Programmable electronics assembly according to one of Claims 1 to 10,
**characterized in that** the region (12) of material weakness comprises a cutout opening (13).

12. Programmable electronics assembly according to one of Claims 1 to 11,
**characterized in that** the region (12) of material weakness runs in the form of a web between the side edges (14) of the projection (8) which are situated opposite one another.

13. Programmable electronics assembly according to Claim 12,
**characterized in that** the side edges (14) of the projection (8) are formed as acute-angled material notches (16) in the region of the region (12) of material weakness.

14. Programmable electronics assembly according to one of Claims 1 to 13,
**characterized in that** the printed circuit board (1) is formed from a rigid, rigidly flexible or flexible printed circuit board structure, wherein a flexible printed circuit board structure is formed, in particular, from polyimide.

15. Programmable electronics assembly according to one of Claims 1 to 14,
**characterized in that** the contact areas (17) are designed as two-sided contact areas, that is to say so-called "bottom and top" contact areas.

16. Programmable electronics assembly according to one of Claims 1 to 15,
**characterized in that** the programmable component (4) has a rectangular, in particular square, basic area, the corner regions (6a) of said basic area lying on the envelope circle (15) or inside or outside the envelope circle (15) of the mounting section (6).

17. Miniature DC motor (20), in particular with a motor diameter of less than/equal to 22 mm, in particular a brushless miniature motor, having an integrated encoder magnet (31) and having a rotor comprising a central rotor shaft (23) on which a rotor magnet (22) is mounted, wherein the rotor is surrounded by a winding (24) and the said winding is surrounded by an iron return path part (26), which winding and iron return path part together form a stator, wherein the stator is surrounded on the outside by a motor housing (27), one end of which is provided with an end cap (28) on the front, in which end cap the rotor shaft (23), in a bearing receptacle, and an encoder magnet (31), which is connected to the rotor shaft (23), are rotatably mounted, wherein an encoder (32) or a rotary encoder, which each form a programmable electronic component (4), is associated with the encoder magnet (31), **characterized in that** the programmable electronic component (4) is contained in a programmable electronics assembly according to one of Claims 1 to 16, wherein the mounting section (6) has a circumferential contour which is formed by its envelope curve (13) and which is matched to the circumferential contour of the motor housing (27), and the projection (8) is dimensioned such that it projects beyond the outside diameter of the motor housing (27), and the region of material weakness (12) is arranged on the outside diameter of the motor housing (27) and/or on the end cap (28) which surrounds the electronics assembly.

18. Miniature DC motor (20) according to Claim 10,
**characterized in that** the envelope curve (15) has a diameter of less than/equal to 20 mm.

19. Miniature DC motor (20) according to Claim 17 or 18,
**characterized in that** the projection (8) runs through a gap (39) between the motor housing (27) and the end cap (28).

## Revendications

1. Bloc électronique programmable destiné à être monté dans un boîtier d'un moteur électrique, comprenant une carte de circuit imprimé (1) munie de pistes électriquement conductrices (1a) et de composants électroniques (5) en contact avec les pistes conductrices (1a), parmi lesquels un composant électronique programmable (4), notamment un composant de capteur tel qu'un codeur ou qu'un capteur de mouvement, et des surfaces de contact électriques (17) connectées aux pistes conductrices (1a) pour venir au contact de broches de contact (36) d'une unité de programmation externe (21), dans lequel la carte de circuit imprimé (1) comporte une partie de montage (6) comportant les composants électroniques (4, 5) ainsi qu'une partie de connexion (7) partant de celle-ci, dans lequel la partie de connexion (7) est réalisée sous la forme de bandes et s'étend en s'éloignant de la partie de montage (6), et un prolongement (8) de la carte de circuit imprimé (1) est réalisé sur la partie de montage (6), lequel prolongement (8) comporte les surfaces de contact électriques (17) destinées à connecter les broches de contact (36) et est relié par l'intermédiaire d'une zone de fragilisation du matériau (12) à la partie de montage (6), dans lequel la zone de fragilisation du matériau (12) se connecte directement à la partie de montage (6),
**caractérisé en ce que** le moteur électrique est un moteur électrique miniature et **en ce que** le prolongement (8) s'étend en ligne droite sur une face opposée à la partie de connexion (7) dans le prolongement de la partie de connexion (7) ou est disposé de manière décalée circonférentiellement par rapport à la partie de connexion (7) d'un angle circonférentiel quelconque et une partie souple (37) est réalisée dans le prolongement (8) entre les surfaces de contact électriques (17) et la zone de fragilisation du matériau (12) de manière à ce qu'une compensation des tolérances soit possible entre les positions de la partie de montage (6) et les tiges de contact (36) devant être mises en contact.

2. Bloc électronique programmable selon la revendication 1,
**caractérisé en ce que** la partie souple (37) est constituée d'un matériau possédant une plus grande flexibilité que le matériau de la partie de montage (6) et/ou que le matériau du prolongement (8) à l'extérieur de la partie souple (37).

3. Bloc électronique programmable selon la revendication 1 ou 2,
**caractérisé en ce que** la partie souple (37) est constituée d'un polyimide.

4. Bloc électronique programmable selon l'une quelconque des revendications 1 à 3,
**caractérisé en ce que** des surfaces de contact électriques (19) en forme de rubans sont prévues à une extrémité du prolongement (8), à son extrémité libre, pour la connexion d'un connecteur électrique, dans lequel les surfaces de contact (19) sont reliées de manière électriquement conductrice aux surfaces de contact (17).

5. Bloc électronique programmable selon l'une quelconque des revendications 1 à 4,
**caractérisé en ce que** le prolongement (8) est composé de deux sections (9, 11), dans lequel une première section (9) reliée à la partie de montage (6) est formée de deux branches (10a, 10b) se rejoignant mutuellement en formant un angle obtus et la deuxième section (11) se raccorde à la branche (10a) de manière orientée radialement vers l'extérieur.

6. Bloc électronique programmable selon la revendication 5,
**caractérisé en ce que** la deuxième section (11) est diamétralement opposée à la partie de connexion (7).

7. Bloc électronique programmable selon la revendication 5 ou 6,
**caractérisé en ce que** les surfaces de contact (17) sont disposées au moins partiellement dans une zone de transition entre les branches (10a, 10b) de la section (9) qui s'étendent l'une vers l'autre en formant un angle obtus.

8. Bloc électronique programmable selon l'une quelconque des revendications 1 à 7,
**caractérisé en ce que** les surfaces de contact (17) sont disposées de manière à ce que leurs centres soient situés sur un arc de cercle, notamment autour du centre (M) de la partie de montage (6).

9. Bloc électronique programmable selon l'une quelconque des revendications 1 à 8,
**caractérisé en ce qu'**une ouverture de passage (18) est réalisée à l'intérieur du prolongement (8) et à l'extérieur de la zone souple (37).

10. Bloc électronique programmable selon la revendication 9,
**caractérisé en ce que** l'ouverture de passage (18) est disposée de manière décalée vers l'extérieur par rapport aux surfaces de contact (36) dans la branche (10a) de la section (9).

11. Bloc électronique programmable selon l'une quelconque des revendications 1 à 10,
**caractérisé en ce que** la zone de fragilisation du matériau (12) comprend une ouverture d'évidement (13).

12. Bloc électronique programmable selon l'une quelconque des revendications 1 à 11,
**caractérisé en ce que** la zone de fragilisation du matériau (12) s'étend sous forme d'une barrette entre les arêtes latérales (14) opposées du prolongement (8).

13. Bloc électronique programmable selon la revendication 12,
**caractérisé en ce que** les arêtes latérales (14) du prolongement (8) sont réalisées sous la forme d'entailles (16) dans le matériau formant des angles aigus dans la région de la zone de fragilisation du matériau (12).

14. Bloc électronique programmable selon l'une quelconque des revendications 1 à 13,
**caractérisé en ce que** la carte de circuit imprimé (1) est formée d'une structure de carte de circuit imprimé rigide, semi-rigide ou souple, dans lequel une structure de carte de circuit imprimé souple est notamment formée de polyimide.

15. Bloc électronique programmable selon l'une quelconque des revendications 1 à 14,
**caractérisé en ce que** les surfaces de contact (17) sont réalisées des deux côtés sous la forme de surfaces de contact dites du type "bottom and top".

16. Bloc électronique programmable selon l'une quelconque des revendications 1 à 15,
**caractérisé en ce que** le composant programmable (4) comporte une surface de base rectangulaire, notamment carrée, dont les zones d'angle (6a) se situent sur le cercle inscrit (15) ou à l'intérieur ou à l'extérieur du cercle inscrit (15) de la partie de montage (6).

17. Moteur miniature à courant continu (20) ayant notamment un diamètre de moteur inférieur ou égal à 22 mm, en particulier, moteur miniature sans balai, comportant un aimant émetteur intégré (31) et un rotor constitué d'un arbre de rotor médian (23) sur lequel est fixé un aimant de rotor (22), dans lequel le rotor est entouré d'un enroulement (24) et ce dernier est entouré d'une partie de fer de compensation (26), qui forment ensemble un stator, dans lequel le stator est entouré extérieurement d'un boîtier de moteur (27) muni à une extrémité, côté avant, d'un capuchon d'extrémité (28), dans lequel l'arbre de rotor (23) est monté tournant dans un réceptacle de support et un aimant émetteur (31) relié à l'arbre de rotor (23) est monté tournant, dans lequel un codeur (32) est associé à l'aimant émetteur (31) ou à un codeur rotatif qui forment respectivement un composant électronique programmable (4),
**caractérisé en ce que** le composant électronique programmable (4) est contenu dans un bloc électronique programmable selon l'une quelconque des revendications 1 à 16, dans lequel la partie de montage (6) présente un contour circonférentiel formé par sa courbe enveloppante (13), laquelle courbe enveloppante est adaptée au contour circonférentiel du boîtier de moteur (27), et le prolongement (8) est dimensionné de manière à ce qu'il fasse saillie par rapport au diamètre extérieur du boîtier de moteur (27), et la zone de fragilisation du matériau (12) est disposée sur le diamètre extérieur du boîtier de moteur (27) et/ou sur le capuchon d'extrémité (28) entourant le bloc électronique.

18. Moteur miniature à courant continu (20) selon la revendication 10,
**caractérisé en ce que** la courbe enveloppante (15) possède un diamètre inférieur ou égal à 20 mm.

19. Moteur miniature à courant continu (20) selon la revendication 17 ou 18,
**caractérisé en ce que** le prolongement (8) passe à travers un interstice (39) entre le boîtier de moteur (27) et le capuchon d'extrémité (28).
